# EUROPEAN PATENT APPLICATION

(11) **EP 4 431 959 A1**
(43) Date of publication of application: **18.09.2024**
(21) Application number: 23178655.9
(22) Date of filing: 12.06.2023
(51) Int. Cl.: G01R 31/36, H01M 10/54

(54) **APPARATUS FOR DISASSEMBLING A POUCH TYPE BATTERY**

(30) Priority: 15.03.2023 KR 20230034124; 25.04.2023 KR 20230053776
(71) Applicant: EMB Co., Ltd., Anyang-si, Gyeonggi-do 14087 (KR); Solargreen Co., Ltd, Siheung-si, Gyeonggi-do 15074 (KR)
(72) Inventor: HONG, Ji Tae, 16824 Yongin-si (KR); JOUNG, Soung Yong, 12821 Gwangju-si (KR)
(74) Representative: Klunker IP Patentanwälte PartG mbB

(57) **Abstract**

The present invention discloses an apparatus for disassembling a pouch type battery that performs a pouch type battery separation process. The apparatus for disassembling a pouch type battery includes a pouch type battery disassembling unit configured to perform a process of transferring and disassembling the pouch type battery; and a controller configured to monitor an operating state of the pouch type battery disassembling unit and control the process of disassembling the pouch type battery by controlling an operation of the pouch type battery disassembling unit. The pouch type battery disassembling unit includes a battery input unit configured to check residual voltages of each of a plurality of input batteries, and divide the batteries on which the residual voltages have been checked into disassembly unsuitable batteries whose measured residual voltages are a predetermined allowable value or more and disassembly suitable batteries whose measured residual voltages are less than the predetermined allowable value, then discharge the disassembly unsuitable batteries to an outside; a pouch removal unit configured to remove a pouch of the disassembly suitable battery; and a 3-stage separation unit configured to separate the battery from which the pouch is removed into a separation membrane, an anode material, and a cathode material, respectively.

## Description

### [CROSS REFERENCE TO RELATED APPLICATIONS]

This application claims the benefit of Korean Patent Applications No. 10-2023-0034124 filed on March 15, 2023 and No. 10-2023-0053776 filed on April 25, 2023, the entirety of which is incorporated by reference herein.

### [BACKGROUND OF THE INVENTION]

### 1. Field of the Invention

The present invention relates to an apparatus for separating components of a battery, and more particularly, to an apparatus for performing a separation process of a pouch type battery.

### 2. Description of the Related Art

A pouch type battery refers to a battery in which battery cells are packaged in a pouch made of an aluminum foil with nylon and CCP film attached thereto. Although there are various types of battery depending on the type of an electrolyte and the shape of an electrode plate to be used, these batteries are collectively called pouch type batteries. The pouch type battery is a secondary battery in which electrodes in the shape of a 'jelly roll' formed by rolling materials such as an anode, a cathode, and a separation membrane, or electrodes in the shape of a 'stack' formed by stacking the materials layer by layer are wrapped in a cell pouch. Compared to cylindrical can or square-shaped batteries, due to a high energy storage density resulted from high internal space efficiency and an flexible exterior, the pouch type battery can be bent or folded freely, thus to be manufactured in an appropriate shape according to the designs of electric vehicles as well as various electronic products. Demand for the pouch type battery is rapidly increasing with the growth of the electric vehicle market based on these strengths.

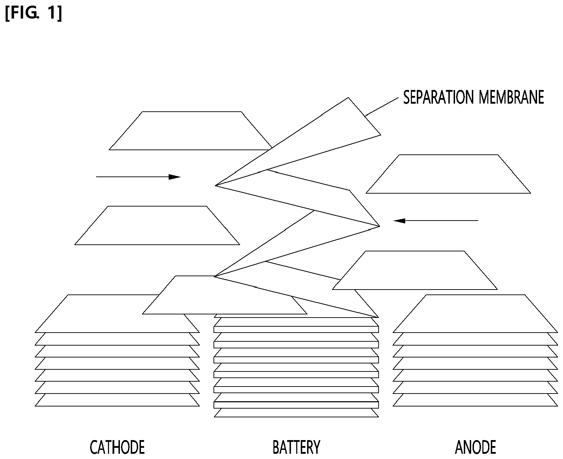

FIG. 1 is a view illustrating a Z-stacking method used during manufacturing a battery.

As shown in FIG. 1, Z-stacking is a method of stacking separation membranes one upon another in a zigzag pattern and inserting cathode materials and anode materials therebetween.

These pouch type batteries do not maintain battery performance after using a certain period, such that they are separated and discharged as waste batteries. As the use of the pouch type battery is increased, a method of efficiently disassembling the pouch type battery and recycling the battery for each disassembled component is required.

### [Prior Art Document]

### [Patent Document]

(Patent Document 1) Korean Patent Registration Publication No. 10-0942410 (entitled a method for disassembling components of a waste battery for recycling, published on February 17, 2010)

### [SUMMARY OF THE INVENTION]

An object of the present invention is to provide an apparatus for disassembling a pouch type battery which is capable of safely and efficiently disassembling waste pouch type batteries in order to efficiently separate components thereof so that the pouch type batteries can be recycled for each disassembled component.

To achieve the above objects, according to an aspect of the present invention, there is provided an apparatus for disassembling a pouch type battery including: a pouch type battery disassembling unit configured to perform a process of transferring and disassembling the pouch type battery; and a controller configured to monitor an operating state of the pouch type battery disassembling unit and control the process of disassembling the pouch type battery by controlling an operation of the pouch type battery disassembling unit, wherein the pouch type battery disassembling unit includes: a battery input unit configured to check residual voltages of each of a plurality of input batteries, and divide the batteries on which the residual voltages have been checked into disassembly unsuitable batteries whose measured residual voltages are a predetermined allowable value or more and disassembly suitable batteries whose measured residual voltages are less than the predetermined allowable value, then discharge the disassembly unsuitable batteries to an outside; a pouch removal unit configured to remove a pouch of the disassembly suitable battery; and a 3-stage separation unit configured to separate the battery from which the pouch is removed into a separation membrane, an anode material, and a cathode material, respectively.

The battery input unit may include: a first transfer part configured to transfer the input battery; and a voltmeter configured to, when the battery input by the first transfer part reaches a voltage measurement position, measure the residual voltage of the reached battery, wherein the controller receives the residual voltage measured from the voltmeter, and controls the first transfer part so that the input battery is discharged again when the received residual voltage is the predetermined allowable value or more.

The pouch removal unit may include: a second transfer part configured to transport a plurality of batteries passing through the pouch removal unit so as to be subjected to each process; a terrace cutter configured to cut terraces T1 and T2, which are ends of two portions of the pouch in a direction in which a cathode tab and an anode tab of the battery are located; a side cutter configured to cut sides S1 and S2 in the battery from which the terraces T1 and T2 are removed by cutting, which are ends of two portions of the pouch in which the cathode tab and the anode tab are not located; an upper cover separator configured to adsorb an upper aluminum cover of the battery, from which four sides including the terraces T1 and T2 and the sides S1 and S2 are removed by cutting, using a high pressure, then separate and discharge the adsorbed upper aluminum cover; a first rotator configured to grasp and lift both ends of the battery from which the upper cover is separated, and rotate 180 degrees so that the battery is upside down; a lower cover separator configured to adsorb a lower cover of the battery rotated 180 degrees by the first rotator using pneumatic pressure, then separate and discharge the adsorbed lower cover; a bare cell pick-and-place device configured to move the battery from which the pouch is removed to the 3-stage separation unit.

The pouch removal unit may further include: a fire detection sensor configured to detect whether a fire has occurred in the battery being transferred; and a cell pusher configured to push the battery when the fire is detected thus to discharge it to the outside, wherein the controller controls an operation of the cell pusher so as to discharge the battery of the fire, in which the fire is detected by the fire detection sensor, to the outside, and drop the battery into a separately prepared salt water container.

The apparatus may include two 3-stage separation units, and the second transfer part may include two conveyors installed in parallel so as to transfer the plurality of batteries to the two 3-stage separation units.

The 3-stage separation unit may include: a separation membrane moving part configured to lift and horizontally move one layer of the separation membrane located at a top of the battery, and after moving the one layer of the separation membrane, pneumatically adsorb the first anode material located at the top and remove by moving it to a central outlet; a second rotator configured to rotate the battery from which the first anode material is removed by 180 degrees; a membrane arranger configured to compress one end of the separation membrane with high pressure, and arrange it on a main body of the battery before 3-stage separation; an adsorber configured pneumatically adsorb the arranged separation membrane and lift one end of the separation membrane; a separation membrane rotating and collecting part configured to rotate and wind the lifted separation membrane thus to be separated, then grasp and discharge the separated separation membrane; an electrolyte dryer configured to blow air onto an electrolyte to dry during removing the separation membrane so that the cathode material and the anode material are separated from the separation membrane, thereby allowing the separated cathode material and anode material to be collected at different locations; and a third transfer part configured to transfer the battery from which the pouch is removed by the 3-stage separation unit, and transfer the separated cathode material and anode material to separate locations.

According to the present invention, it is possible to provide an apparatus for disassembling a pouch type battery which is capable of safely and efficiently disassembling waste pouch type batteries in order to efficiently separate the components thereof so that the pouch type batteries can be recycled for each disassembled component. Through this, it is possible to separate materials included in battery cells into a cathode material, an anode material, and a separation membrane, respectively, thereby increasing recycling efficiency, protecting workers from chemical contaminants generated during work, and improving work efficiency. In particular, it is possible to secure a purity of 99% or more of nickel, cobalt, manganese, lithium, etc., which are raw materials for cathode materials, by increasing a separation efficiency of the cathode materials having a high recycling value at present, and inputting the separated materials into the recycling process.

### [BRIEF DESCRIPTION OF THE DRAWINGS]

The above and other objects, features and other advantages of the present invention will be more clearly understood from the following detailed description taken in conjunction with the accompanying drawings, in which:
FIG. 1 is a view illustrating a Z-stacking method used during manufacturing a battery;
FIG. 2 is a view illustrating a configuration of an apparatus for disassembling a pouch type battery according to an embodiment of the present invention;
FIG. 3 is a view illustrating a process of disassembling the pouch type battery according to an embodiment of the present invention;
FIG. 4 is a block diagram illustrating the detailed configuration of a battery disassembling unit included in the apparatus for disassembling a pouch type battery shown in FIG. 2;
FIG. 5 is a view illustrating the detailed configuration of the pouch type battery disassembling unit shown in FIG. 2;
FIG. 6 is a view illustrating an upper surface of the pouch type battery disassembled by the battery disassembling apparatus shown in FIG. 2 and a state of a bare cell;
FIG. 7 is a view illustrating the configuration of measuring a voltage of the battery in the apparatus for disassembling a pouch type battery shown in FIG. 4;
FIG. 8 is a view illustrating some configurations of a first transfer part and a second transfer part of the apparatus for disassembling a pouch type battery shown in FIG. 4;
FIG. 9 is a view illustrating the configuration of the second transfer part of the apparatus for disassembling a pouch type battery shown in FIG. 4;
FIG. 10 is a view illustrating the configuration of the battery from which a cover is removed by a pouch removal unit shown in FIG. 4;
FIG. 11 is a view illustrating a state where one layer of a separation membrane is lifted and moved in the bare cell shown in FIG. 10;
FIG. 12 is a view illustrating a state where the bare cell, from which a top anode material is removed, is rotated 180 degrees and is upside down;
FIG. 13 is a view illustrating a state where one end of the separation membrane is arranged from FIG. 12;
FIG. 14 is a view illustrating a state where the separation membrane shown in FIG. 13 is wound around a bobbin; and
FIG. 15 is a view illustrating a process of drying an electrolyte when the separation membrane shown in FIG. 13 is wound up.

### [DETAILED DESCRIPTION OF THE INVENTION]

Hereinafter, an embodiment of the present invention will be described in detail with reference to the accompanying drawings. In addition, in description of preferred embodiments of the present invention, the publicly known functions and configurations related to the present invention, which are judged to be able to make the purport of the present invention unnecessarily obscure will not be described in detail. Further, wordings to be described below are defined in consideration of the functions in the present invention, and may differ depending on the intentions of a user or an operator or custom. Accordingly, such wordings should be defined on the basis of the contents of the overall specification.

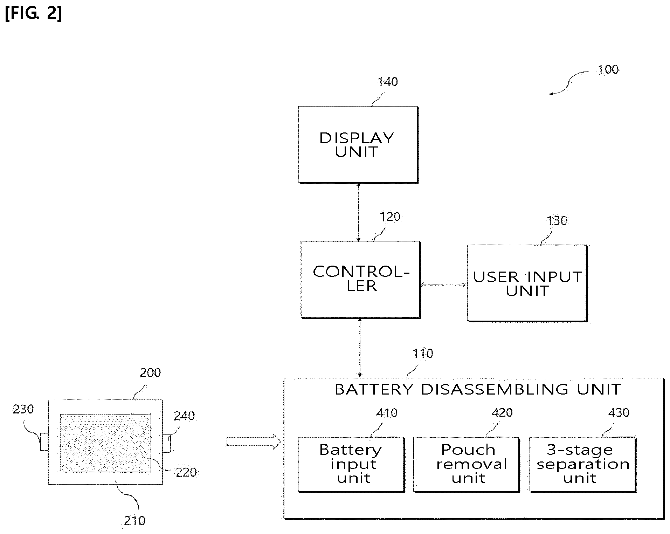

FIG. 2 is a view illustrating a configuration of an apparatus for disassembling a pouch type battery according to an embodiment of the present invention.

An apparatus for disassembling a pouch type battery ("pouch type battery disassembling apparatus") 100 is a facility configured to automatically disassemble a bare cell (or electricity generating element) including an aluminum pouch forming a pouch type battery 200, a jelly roll-shaped cathode material, an anode material, and a separation membrane. By the pouch type battery disassembling apparatus 100, the pouch type battery 200 manufactured in a jelly roll method or Z-stacking method may be safely and efficiently disassembled.

The pouch type battery 200 includes a pouch 210, a bare cell (also referred to as an electricity generating element) 220, a cathode tab 230, and an anode tab 240. The pouch 210 is made of a metal material including aluminum, and has a film coating layer of an electrically insulating polymer material. The bare cell 220 is accommodated in the pouch 210, and an electrolyte (not illustrated) is filled in a predetermined accommodation space formed therein. Here, the bare cell 220 will be described as the same as the battery 200 from which the pouch 210 is removed.

The bare cell 220 includes a plurality of cathode materials (not illustrated), a plurality of anode materials (not illustrated), and a plurality of separation membranes (not illustrated) disposed between the cathode materials and anode materials.

The cathode tab 230 is electrically connected to the cathode materials (not illustrated) in the bare cell 220 and a portion thereof is exposed to an outside of the pouch 210, and the anode tab 240 is electrically connected to the anode materials (not illustrated) in the bare cell 220, and a portion thereof is exposed to the outside of the pouch 210.

The pouch type battery disassembling apparatus 100 may include a battery disassembling unit 110, a controller 120, a user input unit 130, and a display unit 140.

The battery disassembling unit 110 is configured to perform a process of transferring and disassembling the pouch type battery 200. The battery disassembling unit 110 includes a plurality of components for transferring the pouch type battery, disassembling the pouch type battery, and collecting contaminants generated during disassembling the pouch type battery 200. The battery disassembling unit 110 is configured to check residual voltages of each of the plurality of input batteries 200, and divide the batteries 200 on which the residual voltages have been checked into disassembly unsuitable batteries whose measured residual voltages are a predetermined allowable value or more and disassembly suitable batteries whose measured residual voltages are less than the predetermined allowable value, then discharge the disassembly unsuitable batteries to the outside.

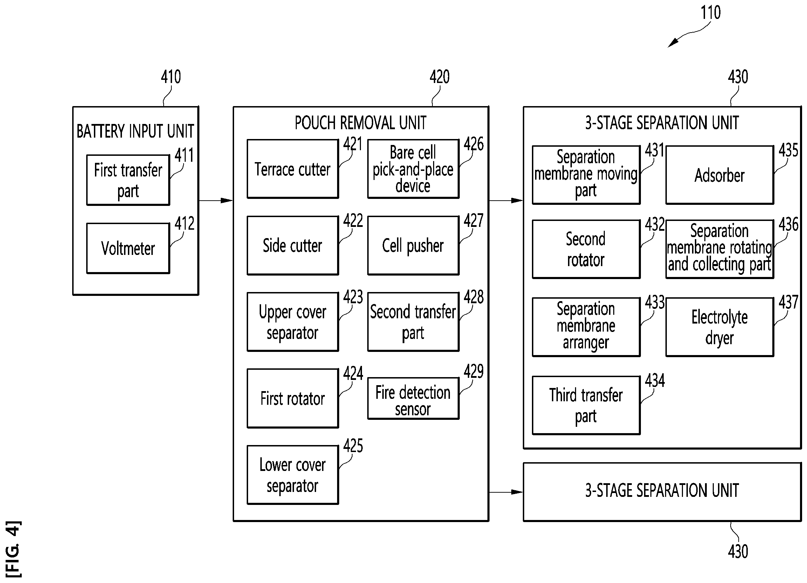

The controller 120 configured to monitor an operating state of the battery disassembling unit 110 and control the process of disassembling the pouch type battery 200 by controlling operations of the plurality of components included in the battery disassembling unit 110. Since the battery disassembling unit 110 includes a plurality of driving modules such as a conveyor (not illustrated) for transferring the battery 200, a pick-and-place device (426 in FIG. 4) for picking up and placing the battery 200, and a plurality of rotators (424 and 432 in FIG. 4) for rotating the battery 200, and pneumatic devices such as a pneumatic adsorber (435 in FIG. 4) for lifting up the separation membrane, and an electrolyte dryer (437 in FIG. 4) including an air injector for drying the separation membrane, the controller 120 is configured to monitor and control motors included in the plurality of the driving modules and the pneumatic devices.

The user input unit 130 may be configured to receive data and signals input from a user necessary for the controller 120 to control the operation of the battery disassembling unit 110 and transfer them to the controller 120.

The display unit 140 may be configured as a display device that displays the detailed operating states and control states of the battery disassembling unit 110, the controller 120, and the user input unit 130.

The facility of the pouch type battery disassembling apparatus 100 may be implemented as follows. For example, the power supply may be 400 [V], 3-phase 4-wire, 50 [HZ], 50 [A](R S T N) or 380 [V], 3-phase 4-wire, 60 [Hz] (it may change depending on the countries or areas to be installed), the air consumption may be 668.8 [LITER/MIN], and the size and weight of a main body thereof may be 1900 (W) x 7400 (L) x 2080 (H) and 2,000 [KG]. The controller 120 may have a size and weight of 1700 (W) x 600 (L) x 2106 (H) and 400 [KG].

A dust collector employed in the pouch type battery disassembling apparatus 100 may be implemented in a way that a power supply of 400 [V], 3-phase 50 [HZ], 20 [A] (R S T N) is used, and a main body thereof has a size and a weight of 900 (W) x 842 (L) x 1982 (H) and 300 [KG].

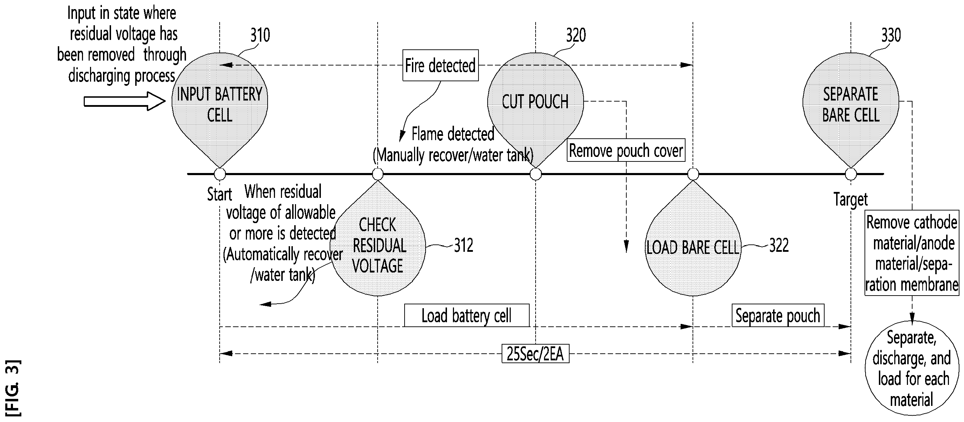

FIG. 3 is a view illustrating a process of disassembling a pouch type battery according to an embodiment of the present invention.

The process of disassembling a pouch type battery according to an embodiment of the present invention may include a battery input step 310, a pouch cutting step 320, and a battery separation step 330.

In the battery input step 310, the battery 200 in a state where the residual voltage has been removed through a discharging process is input. The residual voltage of the input battery 200 is checked, and if it is determined that the checked residual voltage is the predetermined allowable value or more, the battery is recovered without proceeding to the next step (312). In addition, even when an abnormality such as a flame is detected in the input battery 200 by a fire detection sensor (not illustrated), the battery may be put into a separately prepared water tank (not illustrated) or manually recovered. Until the battery input step 310, the battery 200 is loaded while the pouch 210 thereof is maintained.

The pouch cutting step 320 is a process of removing the pouch 210 cover from the battery 200. The bare cell 220 in a state of being removed the pouch 210 is loaded (322).

In the battery (i.e., bare cell) separation step 330, the cathode material, the anode material, and the separation membrane forming the bare cell may be separated, discharged, and loaded for each material.

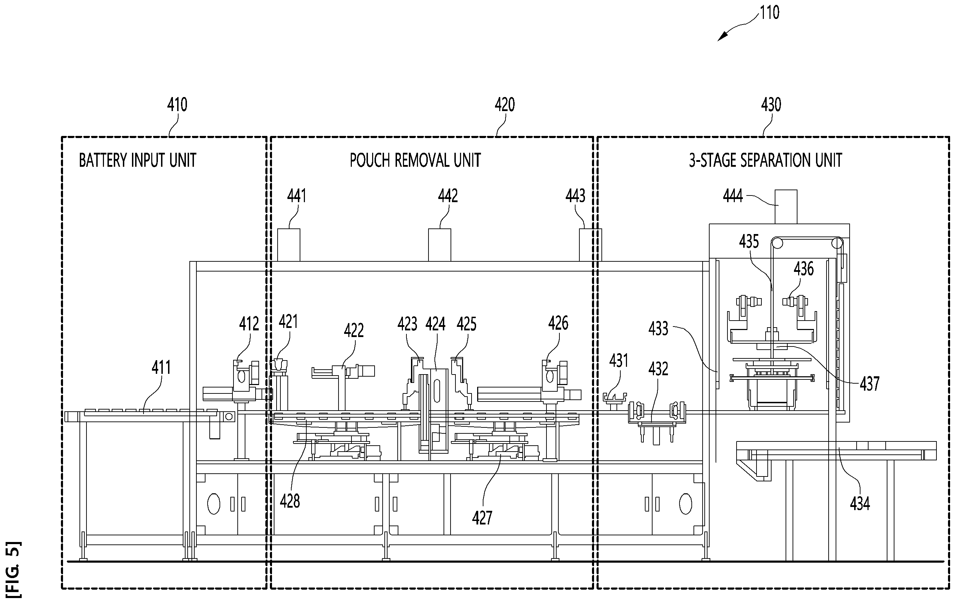

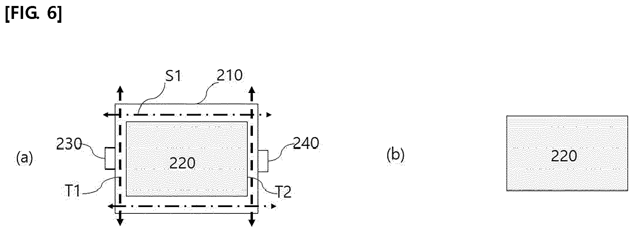

FIG. 4 is a block diagram illustrating the detailed configuration of the battery disassembling unit 110 included in the pouch type battery disassembling apparatus 100 shown in FIG. 2. FIG. 5 is a view illustrating the detailed configuration of the battery disassembling unit 110 shown in FIG. 2. FIG. 6 is a view illustrating an upper surface of the pouch type battery disassembled by the battery disassembling apparatus 100 shown in FIG. 2 and the state of the bare cell.

Referring to FIGS. 4 and 5, the battery disassembling unit 110 may include a battery input unit 410, a pouch removal unit 420, a 3-stage separation unit 430, and dust collectors 441, 442, 443 and 444.

The battery input unit 410 performs a process of transferring the battery and discharging a disassembly unsuitable battery (which may be called an NG cell) determined to be unsuitable for disassembly, a process of loading the battery 200 in order to detect a residual voltage (i.e., open-circuit voltage, OCV) of the transferred battery. The battery input unit 410 includes a first transfer part 411 and a voltmeter 412.

The first transfer part 411 is configured to transfer the battery 200 to the conveyor for the process of transferring and discharging the disassembly unsuitable battery (NG cell), and may include various transport modules (e.g., vacuum cylinders, conveyors) for transferring the battery 200. The battery input unit 410 measures the voltage of the input battery 200 and transfers only a battery, which is determined as a disassembly suitable battery whose measured residual voltage is less than the allowable value by the controller 120, to the pouch removal unit 420. The controller 120 identifies the plurality of input batteries 200, controls the battery input unit 410 so that, when the residual voltage of the identified battery 200 is less than the allowable value, it is classified as a disassembly suitable battery (OK), and if the measured residual voltage of the cells of the identified battery 200 is the allowable value or more, it is classified as a disassembly unsuitable battery (NG cell) to be discharged.

The voltmeter 412 measures a voltage of the battery 200, and when the measured voltage is a set voltage (e.g., it may be set and changed to 0.1 [Vdc]) or more, the controller 120 controls the first transfer part 411 so as to discharge the disassembly unsuitable battery (NG cell) to the outside of the apparatus 100 again. The first transfer part 411 may include a plurality of conveyor devices for the transferring process.

The battery input unit 410 includes a pick-and-place device (not illustrated) which is configured to move the input battery 200 in line to the voltmeter 412 for measuring the residual voltage thereof. The pick-and-place device may be configured as equipment such as a cylinder connected to a vacuum generator (not illustrated) to pick up the battery 200 with a vacuum.

When the battery 200 input by the first transfer part 411 reaches a voltage measurement position, the voltmeter 412 measures the residual voltage of the reached battery 200, and transmits the measured residual voltage value to the controller 120. The voltmeter 412 may include a first probe (not illustrated) which comes into contact with the cathode tab of the battery 200 and a second probe (not illustrated) which comes into contact with the anode tab thereof to measure the residual voltage of the battery 200. If it is determined that the measured residual voltage is the predetermined allowable value (e.g., 0.1 [V]) or more, the controller 120 may control driving of the battery input unit 410 so that the battery 200 is recovered in the input direction again.

The pouch removal unit 420 performs a process of removing the pouch 210 cover from the battery 200 shown in FIG. 3. The pouch removal unit 420 may include a terrace cutter 421, a side cutter 422, an upper cover separator 423, a first rotator 424, a lower cover separator 425, a bare cell pick-and-place device 426, a cell pusher 427, a second transfer part 428, and a fire detection sensor 429.

Even when an abnormality such as a spark is detected in the input battery 200 by the fire detection sensor 429, the battery may be input into a separately prepared water tank (not illustrated) or manually recovered. A plurality of fire detection sensors 429 may be installed at a plurality of locations to detect whether a fire has occurred in the battery 200 in the process of transferring the battery 200 throughout the battery input unit 410 and the pouch removal unit 420.

Referring to FIG. 6, FIG. 6(a) is a view illustrating a state of the battery 200 before being input into the pouch removal unit 420 shown in FIG. 4, and FIG. 6(b) is a view illustrating a state of the battery cell after passing through the pouch removal unit 420.

As shown in FIG. 6(a), the battery 200 is in a state of being wrapped in the pouch 210 before being input into the pouch removal unit 420, and as shown in FIG. 6(b), after passing through the pouch removal unit 420, the battery comes out as the stat of the bare cell 220 from which the pouch 210 is removed. Referring to FIG. 6(a), ends of two portions of the pouch 210 surrounding the bare cell 220 in a direction, in which the cathode tab 230 and the anode tab 240 are located, are referred to as terraces T1 and T2, and ends of the two portions of the pouch 210 surrounding the bare cell 220 in a direction, in which the cathode tab 230 and the anode tab 240 are not located, are referred to as sides S1 and S2. When cutting four sides including the terraces and sides T1, T2, S1 and S2 of the pouch 210, the pouch 210 will be separated into a pouch portion which covers the upper portion of the bare cell 220 (referred to as an upper cover) and a pouch portion placed on the lower portion of the bare cell 220 (referred to as a lower cover).

Referring to FIGS. 4 and 5 again, according to the control of the controller 120, the pouch removal unit 420 moves the battery 200 that has been determined as a disassembly suitable battery to the terrace cutter 421 by the second transfer part 428, and the terrace cutter 421 cuts the terraces T1 and T2 of the transferred battery 200. In order to simultaneously cut two terraces T1 and T2 per one battery 200, two square knives may be used for the terrace cutter 421. The two square knives may cut the terraces T1 and T2 while descending from an upper end of the apparatus 100 to the battery 200.

The battery 200 from which the terraces T1 and T2 are removed by cutting is moved to the side cutter 422, and the side cutter 422 cuts the sides S1 and S2. A circular knife may be used for the side cutter 422. In order to simultaneously cut two sides S1 and S2 per one battery 200, two circular knives may be used for the side cutter 421. The two circular knives cut the sides S1 and S2 while rotating and moving by descending from the upper end of the apparatus 100 to the battery 200.

The upper cover separator 423 adsorbs the upper aluminum cover of the battery, from which the four sides T1, T2, S1 and S2 are removed by cutting, using a high pressure, then separates and discharges the adsorbed upper aluminum cover. The upper cover separator 423 may be configured to adsorb the upper cover using pneumatic pressure, lift the adsorbed upper cover, and move it to an upper cover transfer conveyor (not illustrated) which is separately prepared to transfer the separated upper cover.

The first rotator 424 grasps and lifts both ends of the battery 200, and rotates 180 degrees so that the battery 200 is upside down.

The lower cover separator 425 adsorbs the lower aluminum cover of the battery 200 rotated 180 degrees by the first rotator 424 using pneumatic pressure, then separates and discharges the adsorbed lower aluminum cover. The lower cover separator 425 may be configured to adsorb the lower cover by pneumatic pressure, lift the adsorbed lower cover, and move it to a lower cover transfer conveyor (not illustrated) which is separately prepared to transfer the separated lower cover.

Thus, the bare cell 220, which is a battery in a state where the pouch 210 is removed, is loaded into the 3-stage separation unit 430. The 3-stage separation unit 430 may separate the cathode material, the anode material, and the separation membrane forming the bare cell 220 for each material, then discharge and load the separated materials.

The bare cell pick-and-place device 426 is configured to divide and supply the battery 200 from which all aluminum covers are removed into two 3-stage separation units 430. Specifically, the bare cell pick-and-place device 426 sequentially divides and moves the bare cell type battery 200 from which the cover is removed to the two separation membrane moving parts 431.

The cell pusher 427 is configured, when it is determined that a fire has occurred in the battery 200 based on a signal detected by the fire detection sensor 429, to push the battery 200 of the fire according to the control of the controller 120 and discharge it to an outside of the battery disassembling unit 110, to drop it into a separately prepared salt water container (not illustrated). The cell pusher 427 operates to immerse the battery in salt water by means a cylinder puncher, thereby preventing spread of the fire.

The second transfer part 428 transports the batteries 200 passing through the pouch removal unit 420 so as to be subjected to each process. In order to improve the battery disassembly processing speed, when two 3-stage separation units 430 are provided, the second transfer part 428 may include two conveyors (not illustrated) installed in parallel so as to transfer the plurality of batteries 200 to the two 3-stage separation units.

The 3-stage separation unit 430 may include a separation membrane moving part 431, a second rotator 432, a separation membrane arranger 433, a third transfer part 434, an adsorber 435, a separation membrane rotating and collecting part 436, and an electrolyte dryer 437.

The third transfer part 434 is configured to transfer the transferred battery 200 to a position for each process of the 3-stage separation unit 430. The third transfer part 434 may include a conveyor for transferring the battery 200 to the 3-stage separation unit 430, a driving motor and a cylinder module for performing each process of the 3-stage separation unit 430.

The separation membrane moving part 431 lifts and horizontally moves one layer of the separation membrane located at the top of the bare cell type battery 200, and after moving the one layer of the separation membrane, pneumatically adsorbs the first anode material located at the top and removes by moving it to a central outlet (not illustrated).

The second rotator 432 rotates the battery 200 from which the top anode material is removed by 180 degrees so as to be upside down.

The separation membrane arranger 433 compresses the horizontally moved separation membrane with high pressure, and arranges it on a main body of the battery before 3-stage separation.

The adsorber 435 pneumatically adsorbs the arranged separation membrane and lifts one end of the separation membrane.

The separation membrane rotating and collecting part 436 rotates and winds the lifted separation membrane thus to be separated, then grasps and discharges the separated separation membrane.

The electrolyte dryer 437 blows air onto the electrolyte to dry during removing the separation membrane so that the cathode material and the anode material are separated from the separation membrane, and thereby helping the separated cathode material and anode material to be collected at different locations.

The third transfer part 434 additionally includes a cathode material transfer conveyor (not illustrated) and an anode material transfer conveyor (not illustrated), such that the separated cathode material and anode material can be respectively discharged through the separate conveyors.

The dust collectors 441, 442, 443 and 444 adsorb and collect harmful substances using air when disassembling the battery 200, and then purify and discharge the collected substances.

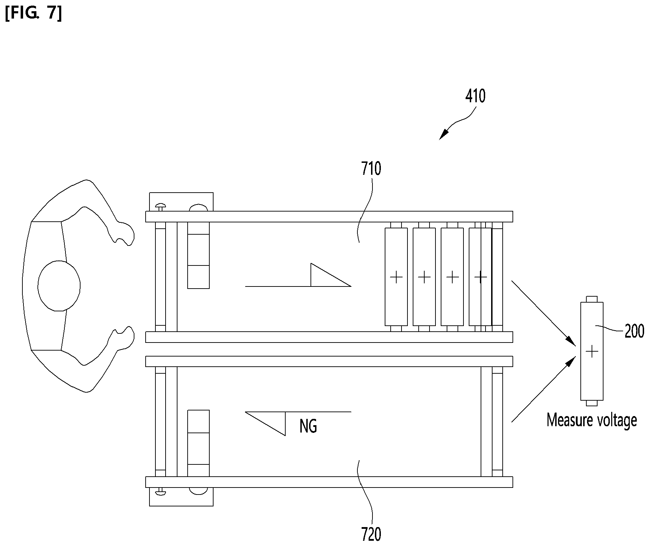

FIG. 7 is a view illustrating the configuration for measuring the voltage of the battery 200 in the pouch type battery disassembling apparatus 100 shown in FIG. 4.

The first transfer part 411 of the battery input unit 410 may include an input conveyor 710 which moves to input the battery 200 into the pouch type battery disassembling apparatus 100 and a discharge conveyor 720 which discharges the disassembly unsuitable battery (NG cell) that has been determined not to be suitable for disassembly after measuring the voltage. The OCV is measured by the voltmeter 412 at the voltage measurement position through the input conveyor 710, and the battery that has been determined to be suitable for disassembly according to the control of the controller 120 is transferred to the second transfer part 428, and the disassembly unsuitable battery (NG cell) is discharged to the outside of the apparatus 100 again using the discharge conveyor 720.

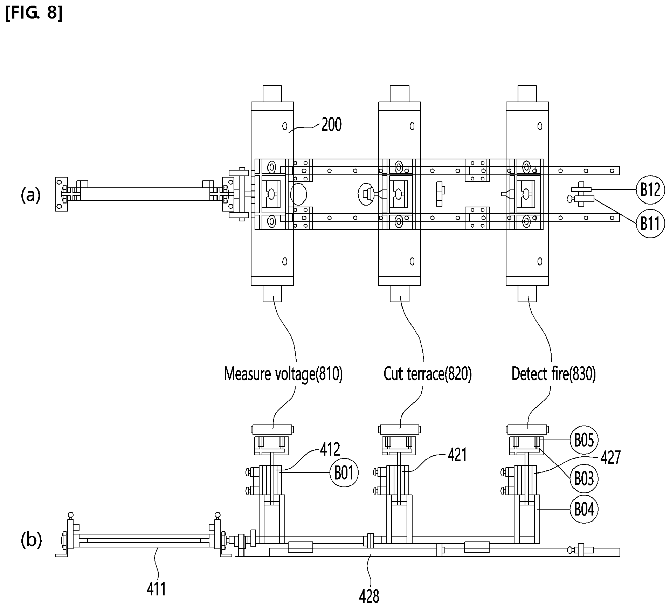

FIG. 8 is a view illustrating some configurations of the first transfer part 411 and the second transfer part 428 of the pouch type battery disassembling apparatus shown in FIG. 4. Specifically, FIG. 8(a) is a plan view illustrating the configuration, and FIG. 8(b) is a side view illustrating the configuration.

When the battery 200 is placed at a voltage measurement position 810 by the first transfer part 411, the residual voltage of the battery 200 is measured by the voltmeter 412, and the battery 200 that has been determined to be suitable for disassembly is moved to the terrace cutting position 820 by the second transfer part 428, such that terrace cutting is performed by the terrace cutter 421. When a fire is detected at a position 830 in the battery 200 where the terrace cutting has been performed, the cell pusher 427 pushes the battery 200 with a constant strength to move it to the salt water container (not illustrated) containing salt water.

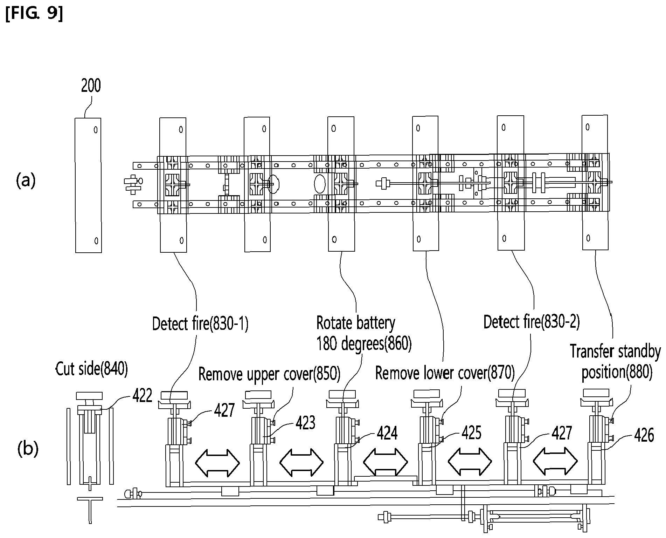

FIG. 9 is a view illustrating the configuration of the second transfer part 428 of the pouch type battery disassembling apparatus shown in FIG. 4. Specifically, FIG. 9(a) is a plan view illustrating the configuration, and FIG. 9(b) is a side view illustrating the configuration.

When the battery 200 is placed at the side cutting position 840 by the second transfer part 428, the side cutter 422 cuts the sides S1 and S2 of the battery 200. If a fire is detected at a fire detection location 830-1 during transferring the battery 200 to the upper cover removal location 850 by the second transfer part 428, the cell pusher 427 pushes the battery 200 with a constant strength or more to move it to the salt water container (not illustrated) according to the control of the controller 120.

When the battery 200 is placed at an upper cover removal position 850, the upper cover of the battery 200 is separated by the upper cover separator 423. When the battery 200, from which the upper cover is separated, is placed at a rotation position 860 by the second transfer part 428, the main body of the battery 200 is rotated 180 degrees by the first rotator 424, such that the battery 200 is upside down and the lower cover of the battery 200 is raised up. When the battery 200 rotated by the second transfer part 428 is placed at a lower cover removal position 870, the lower cover is separated by the lower cover separator 425.

If a fire is detected at a position 830-2 during moving the battery 200, the cell pusher 427 may move the battery 200 of the fire to the salt water container (not illustrated) according to the control of the controller 120. In this way, according to one embodiment of the present invention, it is possible to effectively prevent an occurrence of fire during battery disassembly in such a way that the fire detection sensor 429 and the cell pusher 427 detect a possibility of fire occurring at least three times at locations where the possibility of fire is increased, such as immediately after terrace cutting, immediately after side cutting, and immediately after removing the lower cover, respectively.

When the battery 200 is placed at a transfer standby position 880 by the second transfer part 428, the bare cell battery 200 from which the cover is removed waits before being input into the 3-stage separation unit 430 by the bare cell pick-and-place device 426.

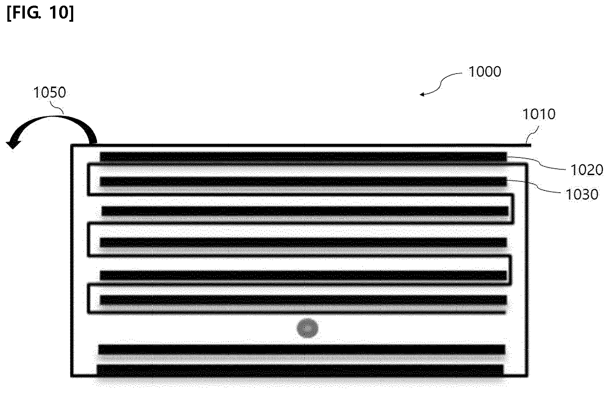

FIG. 10 is a view illustrating the configuration of the battery 200 from which the cover is removed from the pouch removal unit 420 shown in FIG. 4.

A bare cell 1000, which is a battery 200 whose cover is removed, includes separation membranes 1010, a plurality of anode materials 1020, and a plurality of cathode materials 1030.

Referring to FIGS. 4, 9 and 10, the bare cell pick-and-place device 426 may alternately supply the input bare cells 1000 to two 3-stage separation units 430 in sequence. The second transfer part 428 may include two conveyors (not illustrated) so that the bare cells 1000 are sequentially input into the two 3-stage separation units 430.

In the 3-stage separation unit 430 shown in FIG. 4, the separation membrane moving part 431 lifts and horizontally moves the separation membrane 1010 in a direction of an arrow 1050 using pneumatic pressure.

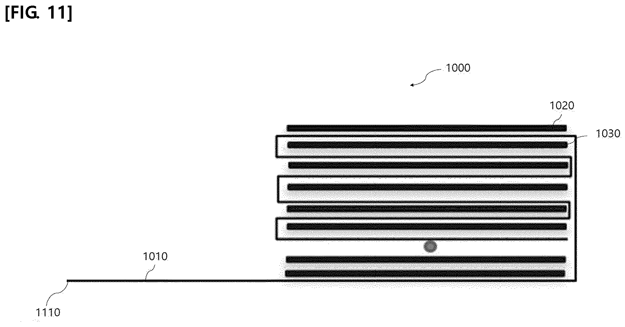

FIG. 11 is a view illustrating a state where one layer of the separation membrane is lifted and moved in the bare cell 1000 shown in FIG. 10.

As shown in FIG. 10, in the 3-stage separation unit 430, when the separation membrane moving part 431 lifts and horizontally moves the separation membrane 1010 in the direction of the arrow 1050 using pneumatic pressure, as shown in FIG. 11, the position of one end 1110 of the separation membrane 1010 is moved from the top to the bottom of the bare cell 1000. In this state, the separation membrane moving part 431 additionally adsorbs one anode material 1020 located at the top of the bare cell 1000 with pneumatic pressure and removes by moving it to the central outlet.

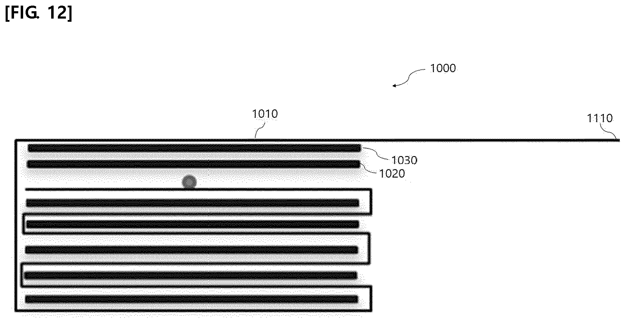

FIG. 12 is a view illustrating a state where the bare cell 1000, from which the top anode material 1020 is removed, is rotated 180 degrees and is upside down.

In FIG. 11, after the anode material 1020 located at the top of the bare cell 1000 is removed, the bare cell 1000 is rotated 180 degrees by the second rotator 432 and is upside down. When the bare cell 1000 is rotated, the position of the one end 1110 of the separation membrane 1010 located at the bottom is changed to the top.

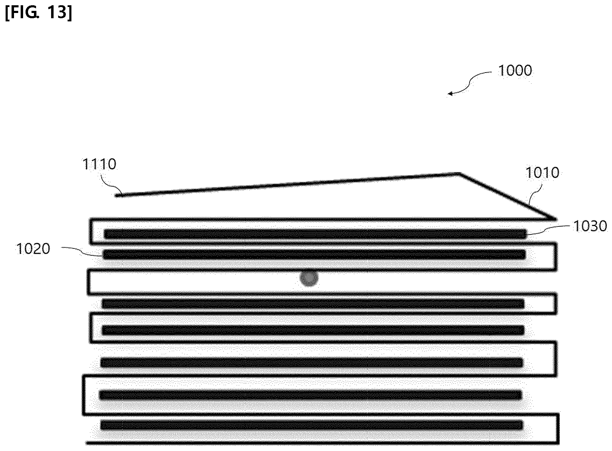

FIG. 13 is a view illustrating a state where the one end 1110 of the separation membrane 1010 is arranged from FIG. 12.

From the state of FIG. 12, the separation membrane arranger 433 compresses the one end 1110 of the separation membrane with pneumatic pressure, and arranges it so as to be placed on the main body of the bare cell 1000. The bare cell 1000 is transferred to the next process position by the third transfer part 434.

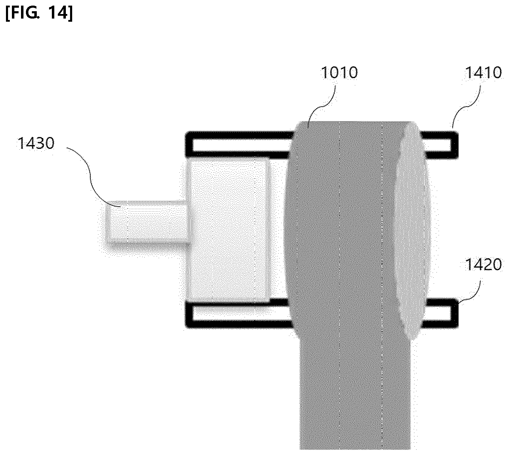

FIG. 14 is a view illustrating a state where the separation membrane 1010 shown in FIG. 13 is wound around a bobbin 1430.

An adsorber 436 grasps the one end 1110 of the separation membrane 1010, hangs the caught one end 1110 on two tongue posts 1410 and 1420 installed on the bobbin 1430 included in the separation membrane rotating and collecting part 436, and rotates the bobbin 1430. Thereby, it is driven so that the separation membrane 1010 hung on the tongue posts 1410 and 1420 is wound and separated.

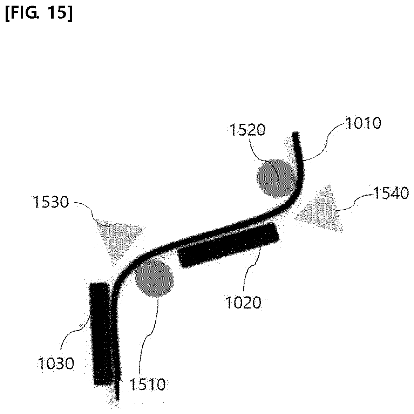

FIG. 15 is view illustrating a process in which the electrolyte is dried when the separation membrane 1010 shown in FIG. 13 is wound up.

Referring to FIGS. 4 and 15, the electrolyte dryer 437 is located at a lower end of the adsorber 436, and dries the electrolyte contained in the separation membrane 1010 so that the anode material 1020 and the cathode material 1030 are smoothly separated from the separation membrane 1010. The electrolyte dryer 437 may include a first air injector 1530 configured to inject air between the two rollers 1510 and 1520 which support the separation membrane 1010 when the separation membrane 1010 is lifted, and between the anode material 1020 and the separation membrane 1010, thereby helping the cathode material 1030 and the separation membrane 1010 to be separated, and a second air injector 1540 configured to inject air between the anode material 1020 and the separation membrane 1010, thereby helping the cathode material 1030 and the separation membrane 1010 to be separated

An aspect of the present invention may be implemented as a computer-readable code in a computer-readable recording medium. The codes and code segments, which implement the above program, may be easily deduced by a computer programmer in the art. The computer-readable recording medium may include all types of recording devices for storing data that can be read by a computer system. Examples of computer-readable recording medium may include ROM, RAM, CD-ROM, magnetic tape, floppy disk, optical disk and the like. Further, the computer-readable recording medium may be distributed over a computer system connected by a network, and written and implemented in computer-readable code that can be read by the computer in a distributed manner.

The above description is merely one embodiment of the present invention, and those skilled art to which the present invention pertains will be able to implement it in a modified form without departing from the essential characteristics of the present invention. Therefore, the protective scope of the present invention is not limited to the above-described embodiment, and should be interpreted to include various embodiments within the scope equivalent to those described in the claims.

### [Description of Reference Numerals]

110: Battery disassembling unit
120: Controller
130: User input unit
140: Display unit
410: Battery input unit
420: Pouch removal unit
430: 3-stage separation unit
440: Dust collector

## Claims

1. An apparatus for disassembling a pouch type battery comprising:
a pouch type battery disassembling unit configured to perform a process of transferring and disassembling the pouch type battery; and
a controller configured to monitor an operating state of the pouch type battery disassembling unit and control the process of disassembling the pouch type battery by controlling an operation of the pouch type battery disassembling unit,
wherein the pouch type battery disassembling unit comprises:
a battery input unit configured to check residual voltages of each of a plurality of input batteries, and divide the batteries on which the residual voltages have been checked into disassembly unsuitable batteries whose measured residual voltages are a predetermined allowable value or more and disassembly suitable batteries whose measured residual voltages are less than the predetermined allowable value, then discharge the disassembly unsuitable batteries to an outside;
a pouch removal unit configured to remove a pouch of the disassembly suitable battery; and
a 3-stage separation unit configured to separate the battery from which the pouch is removed into a separation membrane, an anode material, and a cathode material, respectively.

2. The apparatus for disassembling a pouch type battery according to claim 1, wherein the battery input unit comprises:
a first transfer part configured to transfer the input battery; and
a voltmeter configured to, when the battery input by the first transfer part reaches a voltage measurement position, measure the residual voltage of the reached battery,
wherein the controller receives the residual voltage measured from the voltmeter, and controls the first transfer part so that the input battery is discharged again when the received residual voltage is the predetermined allowable value or more.

3. The apparatus for disassembling a pouch type battery according to claim 1, wherein the pouch removal unit comprises:
a second transfer part configured to transport a plurality of batteries passing through the pouch removal unit so as to be subjected to each process;
a terrace cutter configured to cut terraces T1 and T2, which are ends of two portions of the pouch in a direction in which a cathode tab and an anode tab of the battery are located;
a side cutter configured to cut sides S1 and S2 in the battery from which the terraces T1 and T2 are removed by cutting, which are ends of two portions of the pouch in which the cathode tab and the anode tab are not located;
an upper cover separator configured to adsorb an upper aluminum cover of the battery, from which four sides including the terraces T1 and T2 and the sides S1 and S2 are removed by cutting, using a high pressure, then separate and discharge the adsorbed upper aluminum cover;
a first rotator configured to grasp and lift both ends of the battery from which the upper cover is separated, and rotate 180 degrees so that the battery is upside down;
a lower cover separator configured to adsorb a lower aluminum cover of the battery rotated 180 degrees by the first rotator using pneumatic pressure, then separate and discharge the adsorbed lower cover;
a bare cell pick-and-place device configured to move the battery from which the pouch is removed to the 3-stage separation unit.

4. The apparatus for disassembling a pouch type battery according to claim 3, wherein the pouch removal unit further comprises:
a fire detection sensor configured to detect whether a fire has occurred in the battery being transferred; and
a cell pusher configured to push the battery when the fire is detected thus to discharge it to the outside,
wherein the controller controls an operation of the cell pusher so as to discharge the battery of the fire, in which the fire is detected by the fire detection sensor, to the outside, and drop the battery into a separately prepared salt water container.

5. The apparatus for disassembling a pouch type battery according to claim 3, comprising two 3-stage separation units, and
the second transfer part comprises two conveyors installed in parallel so as to transfer the plurality of batteries to the two 3-stage separation units.

6. The apparatus for disassembling a pouch type battery according to claim 1, wherein the 3-stage separation unit comprises:
a separation membrane moving part configured to lift and horizontally move one layer of the separation membrane located at a top of the battery, and after moving the one layer of the separation membrane, pneumatically adsorb the first anode material located at the top and remove by moving it to a central outlet;
a second rotator configured to rotate the battery from which the first anode material is removed by 180 degrees;
a membrane arranger configured to compress one end of the separation membrane with high pressure, and arrange it on a main body of the battery before 3-stage separation;
an adsorber configured pneumatically adsorb the arranged separation membrane and lift one end of the separation membrane;
a separation membrane rotating and collecting part configured to rotate and wind the lifted separation membrane thus to be separated, then grasp and discharge the separated separation membrane;
an electrolyte dryer configured to blow air onto an electrolyte to dry during removing the separation membrane so that the cathode material and the anode material are separated from the separation membrane, thereby allowing the separated cathode material and anode material to be collected at different locations; and
a third transfer part configured to transfer the battery from which the pouch is removed by the 3-stage separation unit, and transfer the separated cathode material and anode material to separate locations.
